# DEMANDE DE BREVET EUROPEEN

(11) **EP 0 694 871 A1**
(43) Date de publication de la demande: **31.01.1996**
(21) Numéro de dépôt: 94401731.8
(22) Date de dépôt: 27.07.1994
(51) Int. Cl.: G06K 19/077

(54) **Procédé pour l'implantation d'un micro-circuit sur un corps de carte intelligente et/ou à mémoire, et carte comportant un micro-circuit ainsi implanté**

(71) Demandeur: SOLAIC, F-92800 Puteaux (FR)
(72) Inventeur: Audoux, Jean-Noel, F-45100 Orleans (FR); Gaumet, Michel, F-45560 Saint Denis en Val (FR); Gouiller, Michel, F-45160 Olivet (FR); Larchevesque, Alain, F-45150 Ferolles (FR); Thevenot, Benoît, F-45160 Olivet (FR)
(74) Mandataire: Bugnon-Hays, Claudine

(57) **Abrégé**

Le procédé selon l'invention, qui a été mis au point pour implanter un microcircuit sur un corps de carte intelligente et/ou à mémoire en matière thermoplastique, comprend une étape consistant à chauffer le corps de carte (3) au moins au niveau d'une zone d'implantation (8) destinée à recevoir le micro-circuit (2) de façon à ramollir la matière thermoplastique située dans cette zone, une étape consistant à presser le microcircuit (2) contre la matière thermoplastique ramollie, de façon à l'enfoncer dans cette dernière, et une étape consistant à refroidir la matière thermoplastique ramollie après l'étape de pressage.

Il se caractérise en ce qu'il comprend une étape supplémentaire consistant à exercer une pression à chaud sur le micro-circuit implanté (2) et autour de celui-ci, avant, pendant ou après l'étape de refroidissement.

## Description

La présente invention concerne un procédé pour l'implantation d'un micro-circuit sur un corps de carte intelligente et/ou à mémoire en matière thermoplastique, ainsi qu'une carte intelligente et/ou à mémoire comportant un micro-circuit implanté par la mise en oeuvre de ce procédé.

Les procédés qui ont été mis au point jusqu'ici pour implanter des micro-circuits sur les corps de cartes intelligentes et/ou à mémoire comportent des étapes multiples et délicates à réaliser, et entraînent des coûts de production élevés.

Ces procédés exigent en effet généralement la réalisation d'une cavité dans les corps de carte, le collage d'un micro-circuit dans la cavité, l'enrobage du micro-circuit dans une résine synthétique, la polymérisation de cette dernière, etc...

La présente invention se propose plus particulièrement de remédier à ces inconvénients et, pour ce faire, elle a pour objet un procédé d'implantation d'un micro-circuit dans un corps de carte intelligente et/ou à mémoire en matière thermoplastique, qui se caractérise en ce qu'il comprend une étape consistant à chauffer le corps de carte au moins au niveau d'une zone d'implantation destinée à recevoir le micro-circuit, de façon à ramollir la matière thermoplastique située dans cette zone, une étape consistant à presser le micro-circuit contre la matière thermoplastique ramollie, de façon à l'enfoncer dans cette dernière, et une étape consistant à refroidir la matière thermoplastique ramollie après l'étape de pressage.

Il est possible d'ajuster la profondeur d'enfoncement du micro-circuit dans la matière thermoplastique ramollie au cours de l'étape de pressage.

On notera par ailleurs que l'étape de refroidissement peut se dérouler naturellement ou être réalisée de façon contrôlée, et qu'à son issue le micro-circuit se trouve retenu sans qu'il soit nécessaire de prévoir un moyen de fixation externe tel que de la colle.

Afin d'améliorer les gains de productivité, il est préférable que les étapes de chauffage et de pressage soient réalisées simultanément par un outil conçu pour implanter le micro-circuit.

Au cours de l'étape de pressage, la matière thermoplastique ramollie située dans la zone d'implantation est refoulée à la périphérie du micro-circuit où elle forme généralement un bourrelet annulaire.

L'existence de ce bourrelet peut toutefois compliquer la réalisation des étapes de fabrication ultérieures, telles que la formation par sérigraphie des liaisons électriques.

Le procédé conforme à l'invention apporte également une solution à ce problème en prévoyant une étape supplémentaire consistant à exercer une pression à chaud sur le micro-circuit implanté et autour de celui-ci, avant, pendant ou après l'étape de refroidissement.

Cette étape supplémentaire, tout en permettant d'aplanir la face du corps de carte sur laquelle est implanté le micro-circuit, contribue à l'obtention d'une jonction parfaite entre la matière thermoplastique et ce dernier.

Grâce à elle, le procédé d'implantation selon l'invention peut être utilisé favorablement dans un cycle de fabrication de cartes intelligentes et/ou à mémoire, dans lequel les connexions électriques peuvent être réalisées sans problème par sérigraphie.

De préférence, l'étape supplémentaire est réalisée à l'aide d'un poinçon chauffant ayant une surface active plus grande que celle du micro-circuit.

Lorsque la technologie du micro-circuit à implanter nécessite la présence d'une plage de conduction entre la face inférieure de ce micro-circuit et la face supérieure du corps de carte, le procédé selon l'invention peut avantageusement consister à positionner la plage de conduction à cheval sur la zone d'implantation et sur une zone adjacente à celle-ci avant d'effectuer les étapes de chauffage et de pressage.

La plage de conduction, qui peut être constituée par un clinquant de métal ou un dépôt par sérigraphie d'une encre électro-conductrice, peut donc être appliquée à plat sur le corps de carte, puis déformée de sa configuration initiale à sa configuration définitive pendant l'implantation du micro-circuit.

Afin d'améliorer la fixation du micro-circuit sur le corps de carte, il peut être souhaitable de déposer une colle, au moins sur la zone d'implantation, avant d'effectuer les étapes de chauffage et de pressage.

Lorsqu'une plage de conduction est prévue entre la face inférieure du micro-circuit et la face supérieure du corps de carte, la colle utilisée est une colle conductrice pouvant être ou non déposée sur la partie du corps de carte correspondant à la plage de conduction.

Pour augmenter les cadences d'implantation, il peut être avantageux que les étapes de chauffage et de pressage soient réalisées en même temps que l'étape supplémentaire de pressage à chaud et avec le même outil.

Par ailleurs, lorsque le micro-circuit a une épaisseur relativement importante, la zone d'implantation peut être située au niveau d'une cavité ménagée dans le corps de carte lors de la réalisation de ce dernier.

Grâce à cette cavité, on peut éviter un chauffage trop important du corps de carte afin de pouvoir enfoncer le micro-circuit dans la matière thermoplastique.

Plusieurs modes de mise en oeuvre du procédé conforme à l'invention seront décrits ci-après à titre d'exemples nullement limitatifs en référence aux dessins annexés dans lesquels :
- la figure 1 est une vue en perspective schématique et partiellement en coupe d'un outil utilisé pour implanter un micro-circuit sur un corps de carte en matière thermoplastique, cet outil portant un micro-circuit et surplombant un support sur lequel sont disposés plusieurs micro-circuits ;
- la figure 2 est une vue en perspective schématique représentant l'outil de la figure 1 pendant qu'il implante, sur un corps de carte intelligente et/ou à mémoire, le micro-circuit qu'il portait précédemment ;
- la figure 3 est une vue en coupe partielle et à échelle agrandie du corps de carte après implantation ;
- la figure 4 est une vue analogue à la figure 3 mais montrant le corps de carte après aplanissement de la face supérieure de celui-ci ;
- la figure 5 est une vue analogue à la figure 2, mais montrant l'outil avant implantation, alors qu'il est au-dessus d'un corps de carte pourvu d'une plage de conduction ;
- la figure 6 est une vue en coupe partielle et à échelle agrandie d'un corps de carte, juste avant l'implantation d'un micro-circuit avec un autre outil ; et
- la figure 7 est une vue analogue à la figure 6, mais montrant le corps de carte après l'implantation.

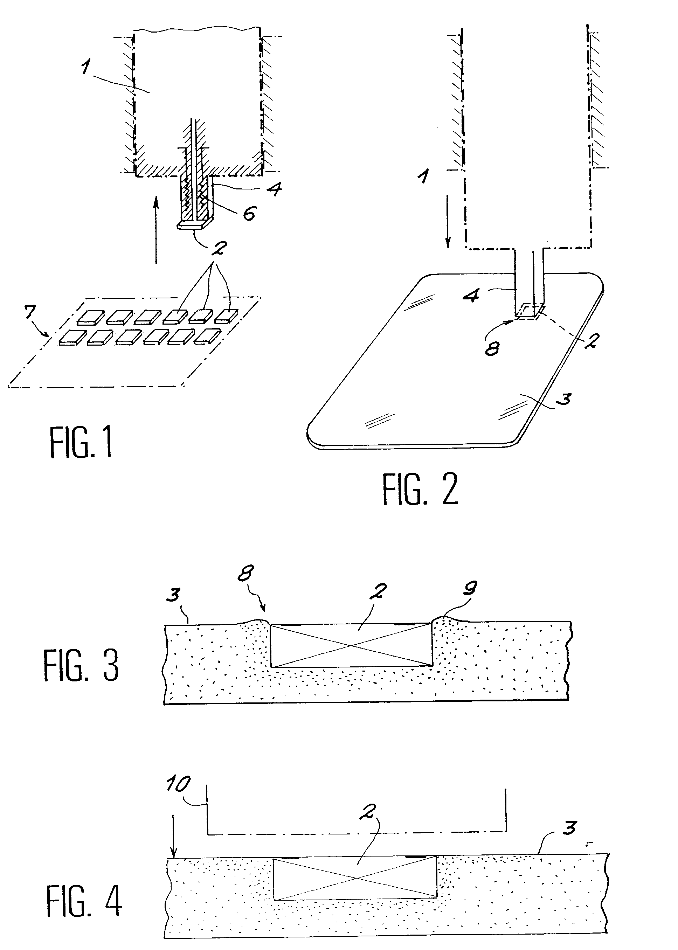

Les figures 1 et 2 représentent schématiquement un outil 1 pouvant être utilisé pour implanter un micro-circuit 2 sur un corps de carte intelligente et/ou à mémoire 3 en matière thermoplastique.

Cet outil, qui est déplaçable verticalement par des moyens classiques non représentés, comprend une protubérance 4 faisant saillie verticalement vers le bas et dont la section transversale a des dimensions de l'ordre de celles du micro-circuit 2.

La protubérance 4 est traversée longitudinalement par un conduit 5 dont l'extrémité inférieure débouche au centre de son extrémité libre et dont l'extrémité supérieure est reliée à une source à vide non représentée.

Elle est par ailleurs pourvue d'un moyen de chauffage interne 6, par exemple une résistance électrique.

Pour implanter un micro-circuit 2 à l'aide de l'outil 1, on commence par positionner l'outil 1 au-dessus d'un support 7 portant plusieurs micro-circuits 2, de telle sorte que sa protubérance 4 surplombe l'un des micro-circuits. Dans le mode de réalisation envisagé ici, le support 7 est constitué par une tranche de silicium sciée, mais il pourrait également être constitué par une boîte alvéolée.

Le moyen de chauffage 6 ayant été préalablement alimenté en énergie, on abaisse l'outil 1 pour appliquer l'extrémité libre de la protubérance 4 contre le micro-circuit 2 à implanter.

On relie alors le conduit 5 à la source à vide et l'on remonte l'outil à sa position d'origine. Sous l'action du vide, le micro-circuit 2 se détache du support 7 et reste appliqué contre l'extrémité libre de la protubérance, comme représenté sur la figure 1.

On transfert maintenant l'outil 1 au-dessus d'une zone d'implantation 8 située en un emplacement approprié sur un corps de carte 3 en matière thermoplastique.

Après ce transfert, on abaisse l'outil 1 de façon à implanter le micro-circuit dans le corps de carte.

Sous l'action combinée de la température et de la pression exercée par l'outil 1, le micro-circuit 2 pénètre à une profondeur prédéterminée, et contrôlée par un asservissement de déplacement, dans la matière thermoplastique ramollie, comme représentée sur les figures 2 et 3.

L'implantation à chaud réalisée par la mise en oeuvre du procédé selon l'invention permet de ne pas avoir recours à une colle, tout en restant compatible avec la mécanisation du processus de fabrication.

On relie ensuite le conduit 5 à l'atmosphère et l'on remonte l'outil 1 à sa position haute d'origine. Le micro-circuit 2 qui n'est plus retenu par le vide contre la protubérance 4 reste alors en place dans la matière thermoplastique, tandis que celle-ci, en se refroidissant naturellement, le retient fermement.

On notera ici que le refroidissement de la matière thermoplastique pourrait, si nécessaire, être contrôlé, par exemple par projection d'un courant d'air à une température régulée, ou par circulation d'un fluide caloporteur dans l'outil 1.

Comme on l'a vu ci-dessus, le micro-circuit 2 est chauffé par l'outil 1 et assure lui-même le ramollissement de la matière thermoplastique contre laquelle il est appliqué.

Il va de soi que l'on ne sortirait pas du cadre de la présente invention si au lieu de prévoir un moyen de chauffage dans l'outil, on utilisait un moyen de chauffage indépendant permettant de chauffer directement tout ou partie du corps de carte 3.

Comme le montre la figure 3, la matière thermoplastique située dans la zone d'implantation 8 a été refoulée à la périphérie du micro-circuit 2 et y a formé un bourrelet annulaire 9.

Celui-ci pouvant gêner la réalisation ultérieure des connexions électriques, par exemple par sérigraphie, il est souhaitable de l'éliminer.

Pour y parvenir, la présente invention propose d'utiliser un poinçon chauffant 10, qui est représenté schématiquement sur la figure 4. Ce poinçon dont les dimensions sont nettement supérieures à celles du micro-circuit, permet d'aplanir la face supérieure du corps de carte 3, d'enfoncer définitivement le micro-circuit dans le corps de carte et d'obtenir une jonction parfaite entre ce dernier et le micro-circuit.

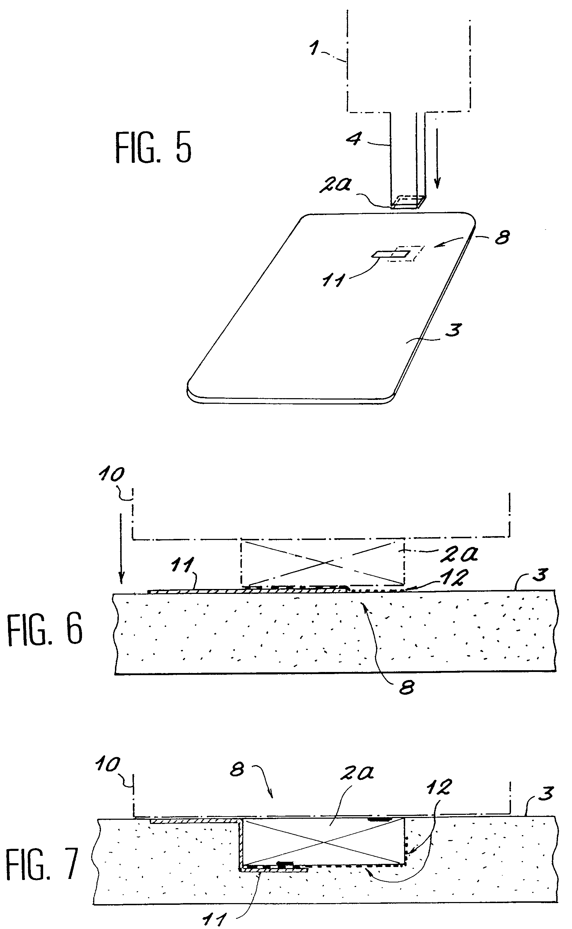

La figure 5 a pour but d'illustrer l'implantation d'un micro-circuit 2a dont la technologie nécessite une plage de conduction 11 entre sa face inférieure et la face supérieure du corps de carte 3.

Comme le montre cette figure, la plage de conduction 11, qui peut être constituée par un clinquant de métal ou une encre électro-conductrice déposée par sérigraphie, est à cheval sur la zone d'implantation 8 et sur une zone adjacente du corps de carte.

Pour implanter le micro-circuit 2a, il convient donc de déposer la plage de conduction 11 à l'emplacement approprié sur le corps de carte 3, et d'effectuer les opérations décrites en référence aux figures 1 à 4.

Les figures 6 et 7 montrent que l'outil 1 peut être remplacé par le poinçon 10, ce qui permet d'implanter le micro-circuit 2a et d'éliminer le bourrelet 9 en une seule opération.

Ces figures montrent également qu'une colle 12 peut être déposée sur tout ou partie de la zone d'implantation 8, cette colle pouvant être réactivable à chaud dans le cas où il n'y a pas de plage de conduction. Dans le cas où une plage de conduction est nécessaire, la colle 12 utilisée est une colle conductrice pouvant être ou non déposée sur la plage de conduction.

Le dépôt de cette colle doit bien entendu être effectué préalablement à l'implantation du micro-circuit 2a.

Pour être complet, on précisera que le corps de carte peut comporter, au niveau de la zone d'implantation, une cavité destinée à recevoir le micro-circuit à implanter, cette cavité pouvant être réalisée par usinage, par exemple lorsque le corps de carte est obtenu par calandrage, ou par moulage, par exemple lorsque le corps de carte est obtenu par moulage par injection.

On notera également que la plage de conduction pourrait être incorporée au corps de carte par moulage transfert, lors du moulage de ce dernier.

Enfin, on précisera que le corps de carte peut être réalisé en n'importe quelle matière thermoplastique, telle que le PVC, l'ABS, le PET et les polycarbonates.

## Revendications

1. Procédé pour l'implantation d'un micro-circuit sur un corps de carte intelligente et/ou à mémoire en matière thermoplastique, comprenant une étape consistant à chauffer le corps de carte (3) au moins au niveau d'une zone d'implantation (8) destinée à recevoir le micro-circuit (2,2a), de façon à ramollir la matière thermoplastique située dans cette zone, une étape consistant à presser le micro-circuit (2,2a) contre la matière thermoplastique ramollie, de façon à l'enfoncer dans cette dernière, et une étape dans laquelle la matière thermoplastique ramollie est refroidie après l'étape de pressage, caractérisé en ce qu'il comprend une étape supplémentaire consistant à exercer une pression à chaud sur le micro-circuit implanté (2,2a) et autour de celui-ci, avant, pendant ou après l'étape de refroidissement.

2. Procédé selon la revendication 1, caractérisé en ce que l'étape supplémentaire est réalisée à l'aide d'un poinçon chauffant (10) ayant une surface active plus grande que celle du micro-circuit (2,2a).

3. Procédé selon la revendication 1 ou 2, caractérisé en ce que les étapes de chauffage et de pressage sont réalisées en même temps que l'étape supplémentaire de pressage à chaud et avec le même outil.

4. Procédé selon l'une quelconque des revendications 1 à 3, pour implanter un micro-circuit nécessitant une plage de conduction entre sa face inférieure et la face supérieure du corps de carte, caractérisé en ce qu'il consiste à positionner la plage de conduction (11) à cheval sur la zone d'implantation (8) et sur une zone adjacente à celle-ci avant d'effectuer les étapes de chauffage et de pressage.

5. Procédé selon l'une quelconque des revendications 1 à 3, caractérisé en ce qu'il consiste à déposer une colle (12), au moins sur la zone d'implantation (8), avant d'effectuer les étapes de chauffage et de pressage.

6. Procédé selon la revendication 5, caractérisé en ce que lorsqu'une plage de conduction est prévue entre la face inférieure du micro-circuit et la face supérieure du corps de carte, la colle (12) utilisée est une colle conductrice pouvant être ou non déposée sur la partie du corps de carte qui correspond à la plage de conduction (11).

7. Procédé selon l'une quelconque des revendications précédentes, caractérisé en ce que la zone d'implantation (8) est située au niveau d'une cavité ménagée dans le corps de carte (3) lors de la réalisation de ce dernier.

8. Carte intelligente et/ou à mémoire comportant un micro-circuit (2,2a) implanté conformément au procédé selon l'une quelconque des revendications précédentes.
